Europäisches Patentamt

(19) European Patent Office

Office européen des brevets

(11) EP 0 816 892 A2

(12) EUROPEAN PATENT APPLICATION

(43) Date of publication:
07.01.1998 Bulletin 1998/02

(51) Int. Cl.⁶: G02B 17/08, G03F 7/20

(21) Application number: 97110124.1

(22) Date of filing: 16.06.1997

(84) Designated Contracting States:
AT BE CH DE DK ES FI FR GB GR IE IT LI LU MC NL PT SE

(30) Priority: 14.06.1996 JP 153770/96

(71) Applicant: Nikon Corporation
Tokyo 140 (JP)

(72) Inventor:
Omura, Yasuhiro,
c/o Nikon Corp.(I.P.H.) Fuji Bldg
Tokyo (JP)

(74) Representative:
Geyer, Ulrich F., Dr. Dipl.-Phys.
WAGNER & GEYER,
Patentanwälte,
Gewürzmühlstrasse 5
80538 München (DE)

(54) Catadioptric lens system

(57) A catadioptric lens system whose entire size is practically compact and is capable of providing a large numerical aperture in the ultraviolet band region is disclosed. The invention also provides photolithographic resolution of quarter micron levels and is easy to manufacture. The invention comprises, a first lens system S1 constructed with refractive members, a concave mirror M1, and a second lens system S2 constructed with refractive members to project a semiconductor device pattern from a reticle surface onto a substrate wherein at least said first lens system includes one or more aspherical surface(s) which point to the reticle surface.

FIG. I

EP 0 816 892 A2

## Description

## BACKGROUND OF THE INVENTION

The present invention relates to the lens system in a projection exposure apparatus used for manufacturing semiconductor devices or liquid crystal devices and the like via photolithographic processing. The invention specifically relates to a catadioptric lens system which is capable of providing a photolithographic resolution of quarter micron levels in the ultraviolet band region by using a reflective mirror as an element of the lens system.

In photolithographic processing for manufacturing semiconductor devices and the like, a projection exposure apparatus is used in which a semiconductor device pattern printed onto a photomask or reticle (hereafter both are referred to as reticle) is exposed via a projection lens system onto a substrate such as a wafer or glass plate (hereafter both are referred to as a wafer) coated with photoresist and the like. As integration of semiconductor devices and the like advances, demand for a projection lens system used in projection exposure apparatus requiring more stringent resolution increases. In order to fulfill this need, using a shorter band illumination light and using a larger numerical aperture (NA) for a projection lens system have become essential. Various technologies have been proposed in order to meet the requirement in which a projection lens system is constructed with a so called "catadioptric lens system" which is a combination of a reflective system and a refractive system.

For example, Japanese patent kokai S63-163319 and kokai H5-25170 disclose a catadioptric lens system which uses an exposure region including light on the optical axis.

In addition, kokai H7-111512 and US 4,779,966 use light on the exposure region of a ring field, rather than light on the optical axis.

In the catadioptric lens system using an exposure region which includes light on the optical axis, a beam splitter having a transmittive reflective surface is required for splitting the optical path. This lens system may easily generate light aberrations, causing flares or uneven illumination on the surface of a wafer. These light aberrations are generated from internal reflections from the wafer surface, from a refractive surface of the lens systems arranged behind the beam splitter, or from the transmittive reflective surface of a beam splitter and the like. A lens system with a larger numerical aperture requires a larger beam splitter and a longer exposure time due to the decrease in light intensity. This in turn, causes a decrease in throughput of the semiconductor manufacturing process. Also, as disclosed in Japanese patent kokai H6-300973, a reflection beam splitter is required to prevent loss of light intensity, however, it is very difficult to manufacture a large reflection beam splitter and its use gives unfavorable imaging performance due to the uneven film thickness of the transmittive reflective layer, which affects the deflection, absorption, and phase change of the light, etc.

On the other hand, in the catadioptric lens system disclosed in US 4,779,966 using a ring exposure field, a reflective lens system is employed on the reduced side toward a wafer surface rather than at an interim image. However, the NA is larger on the reduced side than on the reticle surface side. It is difficult to split the optical path, making it impossible to increase the NA of the lens system. This does not provide excellent resolution. The size of the concave mirror cannot be increased either.

In the catadioptric lens system disclosed in Japanese patent kokai H7-111512 using a ring exposure field, the first lens systemincluding a concave mirror for forming an interim image is constructed with a lens system in perfect symmetry, and the size of the interim image remains the same as the real size of the reticle surface. In this way, the possibility of generating aberrations in the first imaging lens is reduced, however, this gives a heavier load onto the second imaging lens system. Especially, when a large NA is required for the lens system, it is inevitable that the size and complexity of the second lens systemmust be increased.

The present invention intends to resolve the problem by providing a catadioptric lens system whose entire size is essentially compact and is capable of providing a large numerical aperture in the ultraviolet band region to obtain the photolithographic resolution of quarter micron levels and is constructed with components of reduced sizes.

## SUMMARY OF THE INVENTION

In order to accomplish the above object, the present invention provides a catadioptric lens system characterized by the fact that the catadioptric lens system comprises:

a) a first lens system S1 constructed with refractive members,
b) a concave mirror M1, and
c) a second lens system S2 including refractive members to project a semiconductor device pattern from a reticle surface onto a substrate wherein at least said first lens system S1 includes one or more aspherical surface(s) which point to the reticle surface.

The invention further relates to a catadioptric lens system comprising:

a) a first lens system constructed with refractive members,

b) a concave mirror, and

c) a second lens system constructed with refractive members to project a semiconductor device pattern from a reticle surface onto a substrate wherein at least one of the refractive members in the first lens system has at least two different negative refractive powers and wherein another refractive member has at least two different positive refractive powers.

Moreover, the catadioptric lens system of the present invention is further characterized by a) a first lens system constructed with refractive members,

b) a concave mirror, and c) a second lens system constructed with refractive members to project a semiconductor device pattern from a reticle surface onto a substrate wherein the first lens system comprises:

a first lens group in which light enters only once and a second lens group through which light makes a round trip. The lens closest to the concave mirror of the second lens group in the first lens system is a negative lens. Light coming through the second lens group images the semiconductor device pattern once before entering the second imaging lens system.

**BRIEF DESCRIPTION OF THE DRAWINGS**

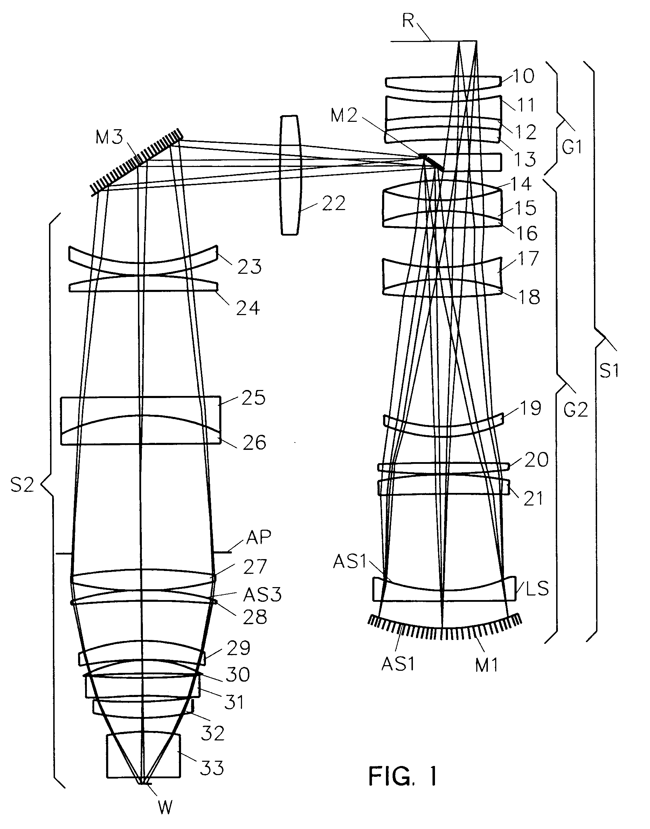

Figure 1 shows a layout of a catadioptric lens system of embodiment 1.
Figure 2 shows an aberration diagram of a catadioptric lens system of embodiment 1.

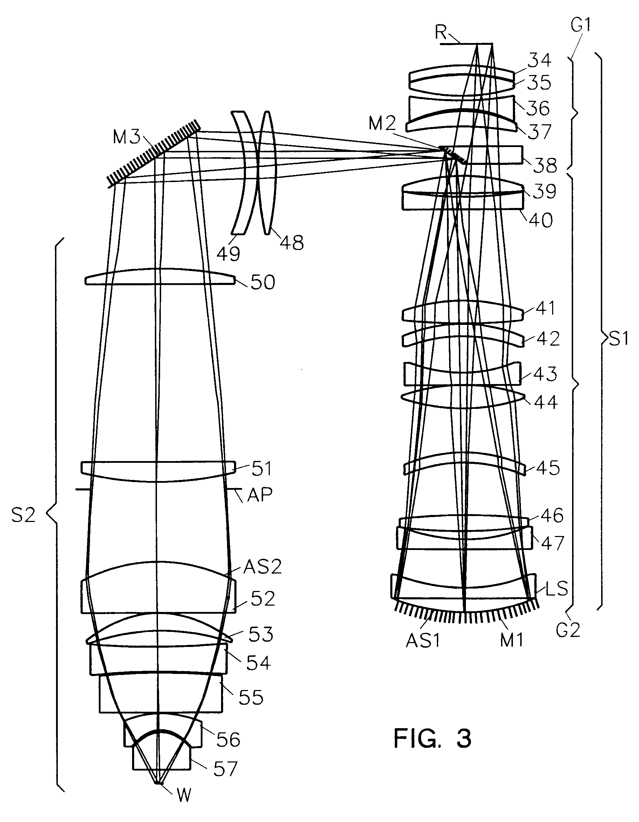

Figure 3 shows a layout of a catadioptric lens system of embodiment 2.
Figure 4 shows an aberration diagram of a catadioptric lens system of embodiment 2.

**BRIEF DESCRIPTION OF THE PREFERRED EMBODIMENTS**

In the present embodiment, as described, the chance of generating aberrations of high orders is reduced and the NA of the lens system is increased, thus preventing an increase in the complexity and size of the lens system. Changing the refractive surface from a spherical surface ideally bends light flux which exists around the lens surface. This makes it possible to correct aberrations of high orders without broadening the entire flux.

Introducing aspherical refractive surfaces to the first lens system S1, prevents increasing the size of it. Introducing aspherical refractive surfaces to the second lens system S2, also prevents increasing the size of it.

Also, it is preferable that the first lens system S1 comprises a first lens group G1, in which light enters only once and a second lens group G2 in which light makes a round trip. The lens closest to the concave mirror M1 of the second lens group G2 is a negative lens LS. Light coming through the second lens group G2 images a semiconductor device pattern once before entering the second lens system S2. This configuration of the lens system especially allows decreasing the size of each of its component members. In addition, the configuration is very effective in reducing chromatic aberration on the axis wherein the configuration includes, in order in which light progresses, a negative lens LS which is closest to the concave mirror M1 in the second lens group G2, a concave mirror M1, and the second lens system S2 wherein the semiconductor device pattern is imaged once before light emitted from the second lens group G2 enters the second lens system S2.

In the lens system of the aforementioned configuration, it is preferable that the second lens group G2 is constructed with a refractive member having at least two different negative refractive powers and a refractive member having at least two different positive refractive powers. The lens having negative refractive powers is effective in correcting coma or spherical aberrations and image curvature and the like. The lens having positive refractive powers is effective in not increasing the size of the lens system and provides a large NA or exposure region. Moreover, it is desirable that each of the members have at least two lenses in order to reduce the load for correcting aberrations of the second lens systemS2.

Also, it is preferable that the first lens group G1 is constructed with refractive members having three different refractive powers. Lately, as the demand for higher resolution increases, more stringent specifications are demanded for correcting distortion, image curvature and the like. It is important for one to adjust these parameters during manufacturing to meet this demand. These adjustments for a lens positioned in the vicinity of the reticle surface work effectively. The second lens group G2 of the present invention, is the lens system for both outgoing and incoming light, which is inappropriate for adjustment lenses. For this reason, constructing the first lens group G1 with lenses having at least three different refractive powers makes it possible to adjust distortion or curvature aberration during manufacturing of lens systems. Also, by utilizing the first lens group G1 in the aforementioned configuration, the working distance in the vicinity of the surface of the reticle R can be increased and a step and scan method of exposure is made possible.

The second lens system S2 plays an important role in correcting mainly spherical or coma aberrations to allow the lens system to have a large NA.

In the present invention, it is preferable to arrange a second optical path reflection member M3 between the first lens system S1 and the second lens system S2 or in the second lens system S2. Also, it is possible to dispose the reflection member M3 in the second imaging lens system. By installing an optical path reflection member such as a mirror, the entire lens system can be bent, reducing its entire size.

Short band wavelengths, in excess of 300nm, are used as the light source in the present invention, therefore, quartz or fluorite are preferable as the material for a refraction member. These minerals are excellent in illumination transmissivity, they are inexpensive, and they are easy to process.

Also in the present invention, the concave mirror M1 can be formed aspherically. If a concave minor M1 is aspherical, the magnitude of the positive refractive power of the concave mirror M1 can be increased without generating aberrations of high orders which makes it possible to manufacture compact lens systems having a large NA and also allows correcting chromatic aberration over a wide bandwidth.

Note that by forming an aperture stop (variable aperture) in the optical path of the second lens system S2, the coherence factor ($\sigma$ value) can be adjusted. A technique to increase focal depth and improve resolution is disclosed for example in Japanese patent kokai S62-50811 in which a phase shift technique is used to shift the phase of a predetermined portion of the reticle pattern from another portion. The present invention provides increased effect of the phase shift technique with adjustment of the coherence factor ($\sigma$ value).

The examples expressed quantitatively for the catadioptric lens system of the present invention are shown herein. The catadioptric lens system in each of the quantitative embodiments comprises, in order from the reticle R side (in the order that light progresses):

a) a first lens system S1 constructed with refractive members,
b) a concave mirror M1, and
c) a second lens system S2 constructed with refractive members to project a semiconductor device pattern from a reticle surface onto a substrate wherein at least one of the refractive members is arranged between the first lens system S1 and the second lens system S2; the first lens system S1 comprises a first lens group G1 through which light goes through only once and the second lens group G2 through which light makes a round trip. The lens closest to the concave mirror M1 in the second lens group G2 of the first lens system is a negative lens LS.

NA=0.6 in each of the quantitative embodiments, and aberrations for the image height are corrected within the range of about 5 to about 18.6. Note that the range for the aforementioned image height may be a ring field or may be a rectangle of 6 x 30 at a distance of 5 from the optical axis.

In each of the tables in embodiments 1 and 2, r denotes surface curvature radius and d denotes a distance between surfaces. Glassy materials are denoted as $SiO_2$ for quartz and $CaF_2$ for fluorite in each of the tables. The refraction rates for quartz and fluorite for n, at 193.0 nm, and for 1/v, which is the dispersion value for those of $\pm$ 0.1nm, are as follows:

|  | n | 1 /v |
|---|---|---|
| synthetic quartz: | 1.56019 | 1780 |
| fluorite | 1.50138 | 2550 |

In each of the embodiments, an aspherical surface is shown by the following equation where:

Z:          distance from the top measured in the direction of the optical axis.
Y:          distance from the top measured in the direction perpendicular to the optical axis.
K:          constant of the cone.
r:          curvature radius of the top.
$C_4$, $C_6$, $C_8$.....:     constants for 4-order, 6-order, 8-order aspherical surface.

$$Z = (Y^2 / r) / [1 + \text{sqrt} \{1 - (1 + K) Y^2 / r\}] + C_4 Y^4 + C_6 Y^6 + C_8 Y^8 + C_{10} Y^{10} + C_{12} Y^{12}$$

In the first embodiment 1, a first lens group G1 comprises, in order from the side of the surface of the reticle R, a biconvex lens 10, a biconcave lens 11, a meniscus lens 12 whose convexity points to the side of the surface of the reticle R, and parallel plane plates 13. The second lens group comprises, in order from the surface of the reticle R, a biconvex lens 14, a biconcave lens 15, a biconvex lens 16, a biconcave lens 17, a biconvex lens 18, a meniscus lens 19 whose concavity points to the side of the surface of the reticle R, a biconvex lens 20, a meniscus lens 21 whose convexity points to the side of the surface of the reticle R, and a negative meniscus lens LS whose concavity points to the surface of the reticle R and is formed with an aspherical surface AS1 on the side of the reticle R. Parallel plane plates 13 in the first lens group G1 comprise a plane mirror M2 which is made by polishing a part of the lens to function as a first optical path reflection member M2. The image of the reticle R is formed once in the vicinity of the plane mirror M2. Also in the present embodiment, the concave minor M1 is formed on an aspherical surface AS2.

In addition, the second lens system S2 comprises, in order from the surface of the reticle R, a biconvex lens 22 (which can be arranged in the second lens system S2 or can be arranged between the first and second lens systems S1and S2 respectively), a meniscus lens 23 whose concavity points to the side of the surface of the reticle R, a biconvex lens 24, a meniscus lens 25 whose convexity points to the side of the surface of the reticle R, a biconvex lens 26, an aperture stop AP, a bioconvex lens 27, a meniscus lens 28 formed with an aspherical surface AS3 whose convexity points to the surface of the reticle R, a meniscus lens 29 whose convexity points to the side of the surface of the reticle R, a meniscus lens 30 whose convexity points to the side of the surface of the reticle R, a biconcave lens 31, a meniscus lens 32 whose concavity points to the side of the surface of the reticle R, and a meniscus lens 33 whose convexity points to the side of the surface of the reticle R. Now, in the present embodiment, a plane mirror M3 is arranged optically between the first lens 22 and the second lens 23 of the second lens system S2 or in the second lens system S2 such that surfaces of a reticle R and a wafer W are arranged in parallel.

| Surface No. | r | d | Glassy material | | |
|---|---|---|---|---|---|
| | 0.000 | 50.000 | | R | |
| 1 | 1827.099 | 25.000 | SiO$_2$ | S1 | G1 |
| 2 | -391.019 | 13.420 | | | |
| 3 | -396.812 | 25.000 | SiO$_2$ | | |
| 4 | 829.284 | 1.000 | | | |
| 5 | 459.609 | 25.000 | SiO$_2$ | | |
| 6 | 745.296 | 1.000 | | | |
| 7 | 488.042 | 25.000 | SiO$_2$ | | |
| 8 | 586.033 | 25.000 | | | |
| 9 | 0.000 | 35.000 | SiO$_2$ | | |
| 10 | 0.000 | 16.000 | | | |
| 11 | 361.664 | 32.175 | CaF$_2$ | | G2 |
| 12 | -449.989 | 1.000 | | | |
| 13 | -561.169 | 20.000 | SiO$_2$ | | |
| 14 | 255.230 | 1.000 | | | |
| 15 | 223.249 | 39.738 | CaF$_2$ | | |
| 16 | -756.196 | 57.483 | | | |
| 17 | -315.859 | 20.000 | SiO$_2$ | | |
| 18 | 299.543 | 1.000 | | | |
| 19 | 260.236 | 32.584 | CaF$_2$ | | |
| 20 | -675.594 | 211.188 | | | |
| 21 | -163.356 | 20.000 | SiO$_2$ | | |
| 22 | -252.267 | 38.241 | | | |
| 23 | 2280.139 | 25.000 | SiO$_2$ | | |
| 24 | -1082.014 | 3.367 | | | |
| 25 | 556.937 | 40.000 | SiO$_2$ | | |
| 26 | 4236.526 | 156.695 | | | |
| 27 | -215.826 | 25.000 | SiO$_2$ | LS | AS1 |
| 28 | -4417.336 | 33.561 | | | |

| | | | | | |
|---|---|---|---|---|---|
| 29 | -354.342 | -33.561 | | M1 | AS2 |
| 30 | -4417.336 | -25.000 | $SiO_2$ | LS | |
| 31 | -215.826 | -156.695 | | | AS1 |
| 32 | 4236.526 | -40.000 | $SiO_2$ | | |
| 33 | 556.937 | -3.367 | | | |
| 34 | -1082.014 | -25.000 | $SiO_2$ | | |
| 35 | 2280.139 | -38.241 | | | |
| 36 | -252.267 | -20.000 | $SiO_2$ | | |
| 37 | -163.356 | -211.188 | | | |
| 38 | -675.594 | -32.584 | $CaF_2$ | | |
| 39 | 260.236 | -1.000 | | | |
| 40 | 299.543 | -20.000 | $SiO_2$ | | |
| 41 | -315.859 | -57.483 | | | |
| 42 | -756.196 | -39.738 | $CaF_2$ | | |
| 43 | 223.249 | -1.000 | | | |
| 44 | 255.230 | -20.000 | $SiO_2$ | | |
| 45 | -561.169 | -1.000 | | | |
| 46 | -449.989 | -32.175 | $CaF_2$ | | |
| 47 | 361.664 | -5.000 | | | |
| 48 | 0.000 | 235.151 | | M2 | |
| 49 | 687.782 | 30.000 | $SiO_2$ | S2 | |
| 50 | -1403.174 | 170.000 | | | |
| 51 | 0.000 | -150.026 | | M3 | |
| 52 | 262.520 | -25.000 | $SiO_2$ | | |
| 53 | 474.401 | -1.304 | | | |
| 54 | -632.711 | -27.786 | $SiO_2$ | | |
| 55 | 5490.382 | -168.081 | | | |
| 56 | -1783.259 | -25.000 | $SiO_2$ | | |
| 57 | -321.439 | -4.402 | | | |
| 58 | -357.850 | -44.750 | $CaF_2$ | | |
| 59 | 3152.678 | -173.787 | | | |
| 60 | 0.000 | -28.467 | | AP | |
| 61 | -566.009 | -45.000 | $CaF_2$ | | |
| 62 | 806.950 | -1.000 | | | |
| 63 | -212.463 | -31.096 | $CaF_2$ | AS3 | |
| 64 | -368.988 | -65.190 | | | |
| 65 | -260.201 | -44.295 | $SiO_2$ | | |
| 66 | -544.105 | -1.000 | | | |
| 67 | -169.071 | -31.373 | $CaF_2$ | | |
| 68 | -824.497 | -9.524 | | | |
| 69 | 1558.569 | -30.000 | $SiO_2$ | | |
| 70 | -466.123 | -8.738 | | | |
| 71 | 7503.078 | -29.965 | $SiO_2$ | | |
| 72 | 566.609 | -15.714 | | | |

| 73 | -197.683 | -64.000 | SiO$_2$ | - |
| 74 | -1633.285 | -17.000 | | |
| 75 | 0.000 | | W | |

The units "r" and "d" are in millimeters (mm).

Constant of the cone, K, and aspherical surface constant, C

| | AS1 | AS2 | AS3 |
|---|---|---|---|
| | r 27 (=r31) | r29 (M1) | r63 |
| K | 0.000000 | 0.000000 | 0.000000 |
| C$_4$ | 0.184947 x 10$^{-8}$ | 0.820832 x 10$^{-9}$ | 0.184651 x 10$^{-8}$ |
| C$_6$ | 0.211178 x 10$^{-12}$ | 0.447187 x 10$^{-13}$ | 0.427327 x 10$^{-13}$ |
| C$_8$ | -0.382898 x 10$^{-17}$ | -0.564120 x 10$^{-18}$ | -0.101914 x 10$^{-17}$ |
| C$_{10}$ | 0.152790 x 10$^{-21}$ | 0.229674 x 10$^{-22}$ | -0.159307 x 10$^{-22}$ |
| C$_{12}$ | -0.561578 x 10$^{-26}$ | -0.558227 x 10$^{-27}$ | 0.167653 x 10$^{-26}$ |

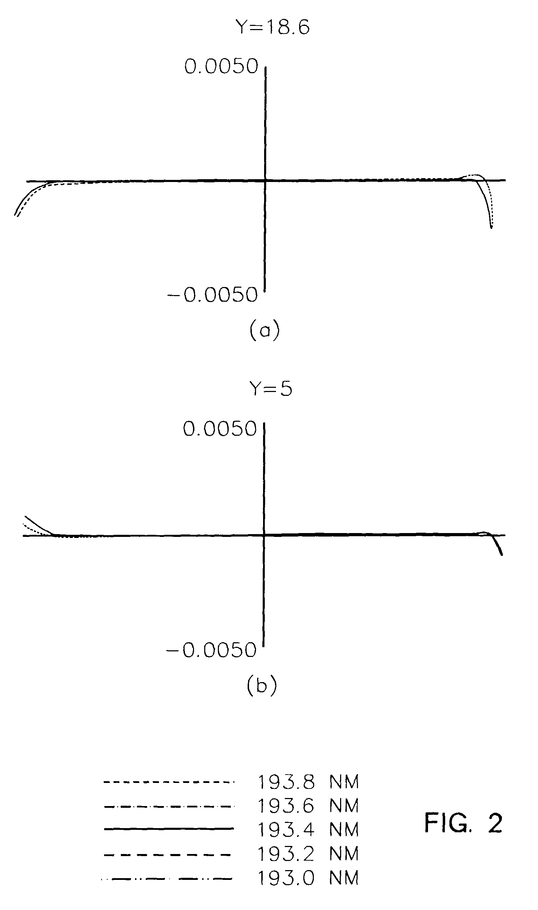

As described above, the required parameters comprise a NA of 0.6, the image height Y of 18.6, and the diameter of about 20 for all optical members of the catadioptric lens system. Figure 2 shows a horizontal aberration diagram for the catadioptric lens system of the present embodiment. Aberrations are measured for each bandwidth using the image height Y = 18.6 for (a) and Y = 5 for (b) with the unit Y in millimeters (mm). As is clear from Figure 2, aberrations are corrected very well by the reflective-refractive optical system of the present embodiment.

In the second embodiment 2, a first lens group G1 of the first lens system comprises, in order from the surface of the reticle R, a meniscus lens 34 whose convexity points to the side of the surface of the reticle R, a biconvex lens 35, a biconcave lens 36, a meniscus lens 37 whose convexity points to the side of the surface of the reticle R, and parallel plane plate 38. The second lens group G2 of the first lens system comprises, in order from the surface of the reticle R, a biconvex lens 39, a meniscus lens 40 whose concavity points to the side of the surface of the reticle, a biconvex lens 41, a meniscus lens 42 whose convexity points to the side of the surface of the reticle R, biconcave lens 43, biconvex lens 44, a meniscus lens 45 whose convexity points to the side of the surface of the reticle R, a biconvex lens 46, a meniscus lens 47 whose concavity points to the side of the surface of the reticle R, and a negative meniscus lens LS whose concavity points to the surface of the reticle R. Parallel plane plates in the first lens group G1 comprises a plane mirror M2 which is made by polishing a surface of the lens to function as an optical reflection member. The image of the reticle R is formed once in the vicinity of the plane mirror M2. Also in the present embodiment, the concave mirror M1 is formed on an aspherical surface AS2.

In addition, the second lens system S2 comprises, in order from the surface of the reticle R, a biconvex lens 48, a meniscus lens 49 whose convexity points to the side of the surface of the reticle R, (the biconvex lens 48 and the meniscus lens 49 may be arranged within the second lens system S2 or between the first and second lens systems S1 and S2 respectively), meniscus lens 50 whose convexity points to the side of the surface of the reticle R, a meniscus lens 51 whose concavity points to the side of the surface of the reticle R, an aperture stop P, a biconvex lens 52 whose surface on the side of the reticle R is formed with an aspherical surface AS2, a meniscus lens 53 whose convexity points to the side of the surface of the reticle R, a biconcave lens 54, a meniscus lens 55 whose convexity points to the side of the surface of the reticle R, a meniscus lens 56 whose convexity points to the side of the surface of the reticle R, and a biconvex lens 57. Now, in the present embodiment, a plane mirror M3 is arranged between the lens 49 and the lens 50 in the second lens system S2 such that surfaces of a reticle R and a wafer W are arranged in parallel.

8

| Surface No. | r | d | Glassy material | | |
|---|---|---|---|---|---|
| | 0.000 | 45.000 | | R | |
| 1 | 281.775 | 18.000 | $SiO_2$ | S1 | G1 |
| 2 | 195.859 | 1.598 | | | |
| 3 | 196.715 | 40.418 | $SiO_2$ | | |
| 4 | -480.361 | 14.536 | | | |
| 5 | -548.718 | 20.000 | $SiO_2$ | | |
| 6 | 204.428 | 5.448 | | | |
| 7 | 203.274 | 20.000 | $SiO_2$ | | |

| | | | | | | |
|---|---|---|---|---|---|---|
| 8 | 401.273 | 25.000 | | | | |
| 9 | 0.000 | 35.000 | $SiO_2$ | | | |
| 10 | 0.000 | 15.500 | | | | |
| 11 | 303.555 | 30.000 | $CaF_2$ | | | G2 |
| 12 | -1740.057 | 5.924 | | | | |
| 13 | -425.354 | 20.000 | $SiO_2$ | | | |
| 14 | -2761.815 | 1.849 | | | | |
| 15 | 300.937 | 40.000 | $CaF_2$ | | | |
| 16 | -2581.928 | 1.849 | | | | |
| 17 | 288.864 | 20.000 | $SiO_2$ | | | |
| 18 | 177.975 | 57.224 | | | | |
| 19 | -175.888 | 20.000 | $SiO_2$ | | | |
| 20 | 764.840 | 0.500 | | | | |
| 21 | 342.881 | 36.406 | $CaF_2$ | | | |
| 22 | -329.279 | 48.341 | | | | |
| 23 | 270.936 | 25.000 | $SiO_2$ | | | |
| 24 | 328.277 | 66.732 | | | | |
| 25 | 778.307 | 40.000 | $SiO_2$ | | | |
| 26 | -518.576 | 15.753 | | | | |
| 27 | -223.579 | 25.000 | $SiO_2$ | | | |
| 28 | -658.513 | 42.435 | | | | |
| 29 | -229.025 | 25.000 | $SiO_2$ | LS | | |
| 30 | -1514.955 | 17.542 | | | | |
| 31 | -332.936 | -17.542 | | | M1 | AS1 |
| 32 | -1514.955 | -25.000 | $SiO_2$ | LS | | |
| 33 | -229.025 | -42.435 | | | | |
| 34 | -658.513 | -25.000 | $SiO_2$ | | | |
| 35 | -223.579 | -15.753 | | | | |
| 36 | -518.576 | -40.000 | $SiO_2$ | | | |
| 37 | 778.307 | -66.732 | | | | |
| 38 | 328.277 | -25.000 | $SiO_2$ | | | |
| 39 | 270.936 | -48.341 | | | | |
| 40 | -329.279 | -36.406 | $CaF_2$ | | | |
| 41 | 342.881 | -0.500 | | | | |
| 42 | 764.840 | -20.000 | $SiO_2$ | | | |
| 43 | -175.888 | -57.224 | | | | |
| 44 | 177.975 | -20.000 | $SiO_2$ | | | |
| 45 | 288.864 | -1.849 | | | | |
| 46 | -2581.928 | -40.000 | $CaF_2$ | | | |
| 47 | 300.937 | -1.849 | | | | |
| 48 | -2761.815 | -20.000 | $SiO_2$ | | | |
| 49 | -425.354 | -5.924 | | | | |
| 50 | -1740.057 | -30.000 | $CaF_2$ | | | |
| 51 | 303.555 | -0.500 | | | | |

EP 0 816 892 A2

| | | | | |
|----|----------|-----------|------------------|------|
| 52 | 0.000 | 233.000 | | M2 |
| 53 | 415.207 | 31.117 | $CaF_2$ | S2 |
| 54 | -631.341 | 0.500 | | |
| 55 | 306.049 | 20.000 | $SiO_2$ | |
| 56 | 218.635 | 150.000 | | |
| 57 | 0.000 | -165.240 | | M3 |
| 58 | -711.482 | -25.000 | $SiO_2$ | |
| 59 | -2123.013 | -302.795 | | |
| 60 | 3482.765 | -30.000 | $SiO_2$ | |
| 61 | 654.764 | -15.000 | | |
| 62 | 0.000 | -59.904 | | AP |
| 63 | -230.331 | -70.000 | $CaF_2$ | AS2 |
| 64 | 1603.607 | -0.500 | | |
| 65 | -204.918 | -28.538 | $SiO_2$ | |
| 66 | -602.518 | -14.615 | | |
| 67 | 1240.449 | -30.000 | $SiO_2$ | |
| 68 | -510.567 | -0.500 | | |
| 69 | -308.492 | -70.000 | $SiO_2$ | |
| 70 | -714.386 | -0.500 | | |
| 71 | -170.397 | -45.000 | $SiO_2$ | |
| 72 | -62.983 | -4.156 | | |
| 73 | -63.147 | -62.343 | $SiO_2$ | |
| 74 | 766.887 | -17.000 | | |
| 75 | 0.000 | | | W |

### Constant of the cone, K, and aspherical surface constant, C

| | AS1 | AS2 |
|----------|-----------------------------|------------------------------|
| | r 31 (M1) | r63 |
| K | 0.000000 | 0.000000 |
| $C_4$ | $0.815186 \times 10^{-9}$ | $0.371510 \times 10^{-8}$ |
| $C_6$ | $0.106110 \times 10^{-13}$ | $0.507303 \times 10^{-13}$ |
| $C_8$ | $0.216157 \times 10^{-18}$ | $0.416256 \times 10^{-18}$ |
| $C_{10}$ | $-0.473987 \times 10^{-23}$ | $0.261764 \times 10^{-22}$ |
| $C_{12}$ | $0.490366 \times 10^{-27}$ | $-0.397276 \times 10^{-27}$ |

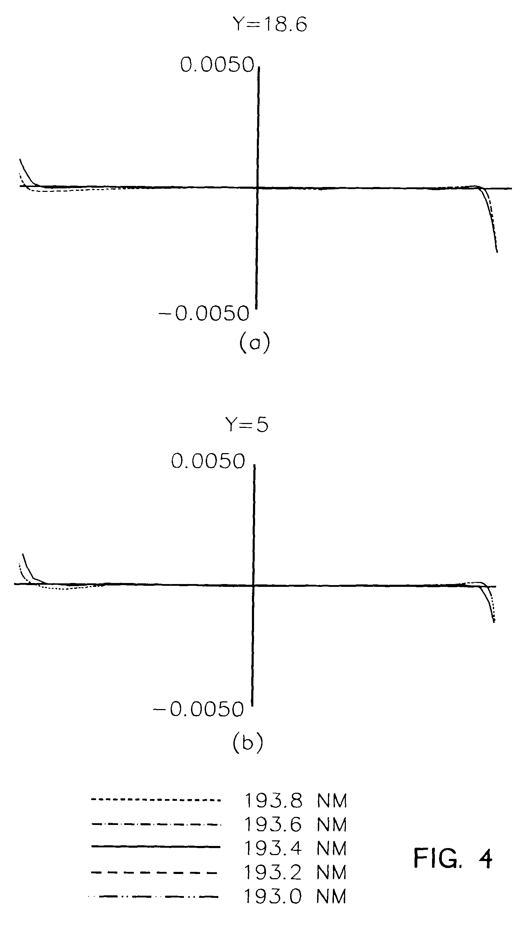

As described above, the required parameters comprise a NA of 0.6, an image height Y of 18.6, and a diameter of about 20 for all optical members of the catadioptric lens system. Figure 4 shows a horizontal aberration diagram for the catadioptric lens system of the present embodiment. Aberrations are measured for each bandwidth using the image height Y = 18.6 for (a) and Y = 5 for (b). As is clear from Figure 4, aberrations are corrected very well by the reflective-refractive optical system of the present embodiment.

As described, the present invention can provide a catadioptric lens system whose entire size is practically compact and is capable of providing a large numerical aperture in the ultraviolet band. The invention also provides photolithographic resolution of quarter micron levels and is easy to manufacture.

11

**Claims**

1. A catadioptric lens system characterized by the fact that said catadioptric lens system comprises:

   a) a first lens system constructed with refractive members,
   b) a concave mirror, and
   c) a second lens system including refractive members to project a semiconductor device pattern from a reticle surface onto a substrate wherein at least said first lens system includes one or more aspherical surface(s) which point to the reticle surface.

2. The catadioptric lens system of claim 1, wherein said first lens system comprises:

   a) a first lens group having a plurality of lenses in which light enters only once; and
   b) a second lens group having a plurality of lenses through which the light exiting from said first lens group makes a round trip with the second lens group including a negative lens located at a position closest to the concave mirror such that the light coming through said second lens group images said semiconductor device pattern once before entering said second imaging lens system.

3. The catadioptric lens system of claim 1, wherein an optical path reflection member is arranged between said first lens system and said second lens system or in said second lens system.

4. The catadioptric lens system of claim 3 wherein said optical path reflection member is a plane mirror.

5. The catadioptric lens system of claim 1, wherein said refractive members in said first lens system and said refractive members in said second lens system are constructed from a mineral selected from the group consisting of quartz and fluorite.

6. The catadioptric lens system of claim 1, wherein said concave mirror is aspherically shaped.

7. The catadioptric lens system of claim 2, wherein an optical path reflection member is arranged between said first lens system and said second lens system.

8. The catadioptric lens system of claim 2, wherein said refractive members in said first lens system and said refractive members in said second lens systemare constructed from a mineral selected from the group consisting of quartz and fluorite.

9. The catadioptric lens system of claim 3, wherein said refractive members in said first lens system and said refractive members in said second lens system are constructed from a mineral selected from the group consisting of quartz and fluorite.

10. The catadioptric lens system of claim 2, wherein said concave mirror is aspherically shaped.

11. The catadioptric lens system of claim 3, wherein said concave mirror is aspherically shaped.

12. The catadioptric lens system of claim 5, wherein said concave mirror is aspherically shaped.

13. The catadioptric lens system of claim 10 wherein at least one of the refractive members in the first lens system has at least two different negative refractive powers and wherein another refractive member has at least two different positive refractive powers.

FIG. 1

Y=18.6

(a)

Y=5

(b)

| | |
|---|---|
| ---------- | 193.8 NM |
| -·-·-·-·- | 193.6 NM |
| ———— | 193.4 NM |
| --------- | 193.2 NM |
| -··-··-··- | 193.0 NM |

FIG. 2

FIG. 3

Y=18.6

0.0050

−0.0050

(a)

Y=5

0.0050

−0.0050

(b)

```
-------------------    193.8 NM
-----·----·---·--      193.6 NM
———————————            193.4 NM
- - - - - - -          193.2 NM
—·——·——·—              193.0 NM
```

FIG. 4